# EUROPEAN PATENT APPLICATION

(11) **EP 4 730 945 A1**
(43) Date of publication of application: **22.04.2026**
(21) Application number: 25209679.7
(22) Date of filing: 20.10.2025
(51) Int. Cl.: H10B 12/00, G11C 11/403, H10D 30/67

(54) **HYBRID OXIDE-SEMICONDUCTOR AND POLY-SI TRANSISTORS FOR HIGH DENSITY 2T0C GAIN CELL EDRAM**

(30) Priority: 21.10.2024 US 202463709875 P; 12.09.2025 US 202519327398
(71) Applicant: Samsung Electronics Co., Ltd., Suwon-si, Gyeonggi-do 16677 (KR)
(72) Inventor: AHOSAN UL KARIM, Muhammed, San Jose, CA 95134 (US); SIMKA, Harsono, San Jose, CA 95134 (US); ZHU, Xuelian, San Jose, CA 95134 (US); KUMAR, Aravindh, San Jose, CA 95134 (US)
(74) Representative: Kuhnen & Wacker Patent- und Rechtsanwaltsbüro PartG mbB

(57) **Abstract**

A device includes a two transistor zero capacitor gain cell (1) that is back end of line compatible and includes a write transistor (Tw) and a read transistor (Tr) that is electrically connected to the write transistor (Tw). The write transistor (Tw) includes an oxide semiconductor channel and the read transistor (Tr) includes a polysilicon channel.

## Description

### BACKGROUND

The preponderance of artificial intelligence (AI) in modern society has enabled a wide range of transformative new applications in areas ranging from natural language processing to cancer diagnostics. Today's AI algorithms are highly memory bound. However, limited main memory capacity and bandwidth are bottlenecks, and data movement from DRAM is expensive.

There is a need for high speed, high density, high energy efficient memory to help mitigate the current energy intensive architecture used for AI accelerators. High-density and large capacity on-chip memories can alleviate main memory capacity and bandwidth bottlenecks.

### SUMMARY

It is an aspect to provide a high reliability, back end of line (BEOL) compatible two transistor zero capacitor (2T0C) gain cell implementation for high density embedded dynamic random access memory (eDRAM).

According to an aspect of one or more embodiments, there is provided a device comprising a two transistor zero capacitor gain cell in in a back end of line structure, the two transistor zero capacitor gain cell including a write transistor and a read transistor that is electrically connected to the write transistor. The write transistor includes an oxide semiconductor channel and the read transistor includes a polysilicon channel.

According to another aspect of one or more embodiments, there is provided system comprising a front end of line structure comprising a logic chip; and a back end of line structure on the front end of line structure, the back end of line structure including a layer. The layer comprises a two transistor zero capacitor gain cell including a read transistor, and write transistor that is electrically connected to the read transistor. The write transistor includes an oxide semiconductor channel and the read transistor includes a polysilicon channel.

According to yet another aspect of one or more embodiments, there is provided a method comprising fabricating a first structure using a front end of line process, the first structure including a logic chip; fabricating a first tier using a back end of line process, the first tier comprising a read transistor of a two transistor zero capacitor gain cell; and fabricating a second tier on the first tier using the back end of line process, the second tier including a write transistor of the two transistor zero capacitor gain cell.

### BRIEF DESCRIPTION OF THE DRAWINGS

The above and/or other aspects will become apparent and more readily appreciated from the following description of various embodiments, taken in conjunction with the accompanying drawings, in which:
FIG. 1 illustrates a two transistor zero capacitor (2T0C) gain cell, according to some embodiments;
FIG. 2 illustrates an example of a semiconductor memory device, according to some embodiments;
FIGS. 3 and 4 illustrate a plan view of tiers of an exemplary layout of the 2T0C gain cell of FIG. 1, according to some embodiments;
FIG. 5 illustrates a plan view of an exemplary composite layout of the 2T0C gain cell of FIG. 1, according to some embodiments;
FIGS. 6 to 9 illustrate cross-sectional views taken along lines A-A', B-B', C-C', and D-D' in FIG. 5, respectively, according to some embodiments;
FIGS. 10 and 11 illustrate a plan view of tiers of an exemplary layout of the 2T0C gain cell of FIG. 1, according to some embodiments;
FIGS. 12 and 13 illustrate cross-sectional views of an example of an embedded dynamic random access memory (eDRAM), according to some embodiments;
FIG. 14 illustrates a cross-sectional view of an example of a semiconductor memory device, according to some embodiments;
FIG. 15 illustrates a three-dimensional (3D) eDRAM having monolithic integration, according to some embodiments;
FIG. 16 illustrates a 3D eDRAM having heterogeneous integration, according to some embodiments;
FIG. 17 illustrates a flowchart showing a method of manufacturing an embedded dynamic random access memory (eDRAM), according to some embodiments; and
FIG. 18 illustrates a flowchart showing a method of manufacturing an embedded dynamic random access memory (eDRAM), according to some embodiments.

### DETAILED DESCRIPTION

As used in this specification, the phrase "at least one of A, B, or C" includes within its scope "only A", "only B", "only C", "A and B", "B and C", "A and C", and "A, B, and C." It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section and do not denote any particular order unless an order is specifically described. Thus, a "first" element, component, region, layer or section described below could be termed a "second" element, component, region, layer or section, without departing from the spirit and scope of the present disclosure. It is noted that components in the drawings are not necessarily drawn to scale and some components may be exaggerated for clarity of description.

The present disclosure relates to a hybrid two transistor zero capacitor (2T0C) gain cell and, more specifically, to an embedded dynamic random access memory (eDRAM) using the same.

A 2T0C gain cell eDRAM is an on-chip memory option in which a transistor functions as both a storage element and a source of amplification providing a gain. The 2T0C gain cell can include a type of cell that uses two transistors and zero capacitors for data storage. Unlike in one transistor one capacitor (1T1C) DRAM cells that rely on a capacitor to store charge, the 2T0C gain cells store data using a gate capacitance of a read transistor. The 2T0C gain cell provides advantages in that the 2T0C gain cell is suitable for 3D stacked memory architectures, uses lower power, and is easier to fabricate because there is no need to fabricate a capacitor.

The write transistor of the 2T0C gain cell may use a low off-state current which can be enabled by oxide-semiconductor (OS) based transistors. However, OS based transistors may have reliability issues such as Negative Bias Temperature Instability (NBTI) and/or Positive Bias Temperature Instability (PBTI). NBTI can include a mechanism in which a p-channel degrades over time due to application of a negative gate voltage at elevated temperatures. This degradation causes a shift in the transistor's threshold voltage and a decrease in drain current, which may lead to circuit malfunction. NBTI is influenced by temperature, gate voltage, time, gate oxide thickness, device area, and geometry, and is primarily caused by creation of interface traps at the silicon-oxide interface. The interface traps are generated when Si-H bonds break due to the applied electric field and due to the presence of holes. PBTI occurs when a positive voltage is applied to the gate of the transistor at elevated temperatures. PBTI can lead to a shift in the transistor's threshold voltage. The shift in threshold voltage may reduce the transistor's drive current ad may increase leakage. PBTI is caused by the trapping of electrons within the gate dielectric material. The trapped electrons create a negative charge that degrades the transistor performance. Some OS based transistor-based gain cell eDRAM may degrade because of NBTI and PBTI stability issues.

To address the stability issues with OS based transistors, a 2T0C gain cell may be implemented in which an OS based transistor and a crystalline silicon-based transistor are used. However, high temperature processing is used to fabricate the crystalline silicon-based transistor and thus the crystalline silicon-based transistor is not back end of line (BEOL) compatible but rather is implemented in a front end of line (FEOL) structure which allows for high temperature processing. The crystalline silicon-based transistor takes additional FEOL area, causing an area penalty and hence can be disadvantageous for high density memory.

Various embodiments herein provide a hybrid 2T0C gain cell implementation that is BEOL compatible and may be used in a high density eDRAM. The hybrid 2T0C gain cell includes an OS based write transistor and a polysilicon based read transistor which suppress the reliability concerns and are fully BEOL compatible. In some embodiments, a polysilicon channel material may be used for the read transistor of the 2T0C gain cell to address reliability issues. OS has some NBTI but severe PBTI. In comparison to OS, polysilicon has improved NBTI and PBTI performance. Write transistors in a 2T0C gain cell are less prone to PBTI and, due to the low leakage of the write transistors, write transistors may be OS based. Read transistors of the 2T0C gain cell are more prone to both NBTI and PBTI and thus polysilicon provides better performance than OS because high leakage is less of an issue for read transistors.. In some embodiments, an OS based write transistor may be stacked with a polysilicon based transistor to form a stacked structure for the 2T0C gain cell, where the stacked structure is a BEOL stacked structure that is compatible with a BEOL process. In some embodiments, the 2T0C gain cells may be stacked to form a 3D embedded DRAM. Various embodiments provide a high density memory, that is fully BEOL compatible with improved reliability as compared to a memory using an OS based transistor and a crystalline silicon-based transistor due to the improved NBTI and PBTI performance of the polysilicon.

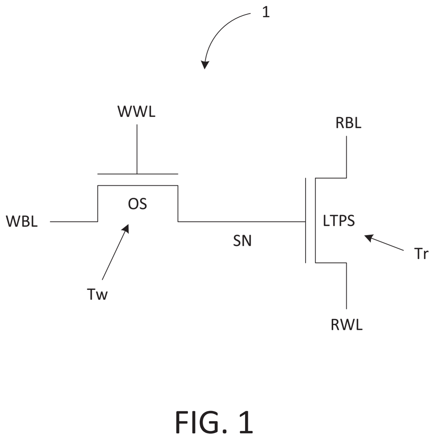

FIG. 1 illustrates an example of a 2T0C gain cell, according to some embodiments. In an embodiment, a 2T0C gain cell 1 may include a write transistor Tw and a read transistor Tr. The write transistor Tw has a gate that is electrically connected to a write word line (WWL), a first source/drain electrically connected to a write bit line (WBL), and a second source/drain electrically connected to a storage node (SN). The read transistor Tr has a gate electrically connected to the storage node SN, a first source/drain electrically connected to a read bit line (RBL), and a second source/drain electrically connected to a read write line (RWL). In an embodiment, the gate of the write transistor Tw may be directly connected to the WWL, the first source/drain of the write transistor Tw may be directly connected to the WBL, and the second source/drain of the write transistor Tw may be directly connected to the storage node SN, and the gate of the read transistor Tr may be directly connected to the storage node SN, the first source/drain of the read transistor Tr may be directly connected to RBL, and the second source/drain of the read transistor Tr may be directly connected to the RWL.

In an embodiment, the write transistor Tw may be an OS based transistor. In an embodiment, the OS based transistor may have an oxide semiconductor channel. For example, the oxide semiconductor may be selected from, but is not limited to, IGZO (InGaZnO), Sn-IGZO, IWO (InWO), IZO (InZnO), ZTO (ZnSnO), ZnO, YZO (yttrium-doped zinc oxide), IGSO (InGaSiO), InO, SnO, TiO, ZnON, MgZnO, ZrInZnO, HfInZnO, SnInZnO, AlSnInZnO, SiInZnO, AlZnSnO, GaZnSnO, or ZrZnSnO, or a combination thereof.

In an embodiment, the read transistor Tr may be a polysilicon (poly-Si) based transistor which is BEOL compatible. In an embodiment, the poly-SI based transistor may have a poly-SI channel. In some embodiments, the poly-Si based transistor may be formed using low temperature polysilicon (LTPS) which is compatible with a BEOL process which uses low temperatures (e.g., less than about 400° C) that are lower than the comparatively high temperatures (e.g., greater than 1000 ° C) used in a FEOL process.

In an embodiment, the 2T0C gain cell 1 may be formed as part of a stacked structure. In an embodiment, the stacked structure may be a BEOL stacked structure having monolithic integration that is compatible with a BEOL process. For example, the write transistor Tw may be formed in a different tier of a BEOL structure of a semiconductor memory device from the read transistor Tr, as will be described in more detail below. For example, in the BEOL structure of a semiconductor memory device, a plurality of tiers may be formed using a low temperature process (e.g., processing at temperatures less than about 400° C). As used herein, a tier may denote a stacked functional block or active device plane, such as a transistor tier. In some contexts, the tiers may correspond to levels or metal interconnect layers of a BEOL stacked structure. In an embodiment, the read transistor Tr may be formed in a first tier of the plurality of tiers, and the write transistor Tw may be formed in a second tier of the plurality of tiers. In an embodiment, the first tier may be hybrid bonded to the second tier. In an embodiment, the second tier that includes the write transistor Tw may be disposed on top of the first tier that includes the read transistor Tr. However, this is only an example and, in some embodiments, the tier that includes the read transistor Tr may be disposed on top of the tier that includes the write transistor Tw. In an embodiment, the read transistor Tr in the first tier may be electrically connected to the write transistor Tw in the second tier by a vertical electrical connection, such as a via, formed between the first tier and the second tier. In an embodiment, the storage node SN of the 2T0C gain cell 1 may be provided by a parasitic capacitance of the via between the first tier and the second tier. A description of various layout structures of the 2T0C gain cell 1 is provided in more detail below.

In an embodiment, in a write operation, voltages on the RWL and the RBL may be zero and the read transistor Tr may be turned off. A high potential may be applied to the WWL, and the write transistor Tw may be turned on. A voltage may be applied to the WBL and the voltage may be written to the SN. For example, in an embodiment, if the WBL is a high potential, the SN may be charged to a voltage close to as supply voltage (VDD), and if the WBL is a low potential, the SN may be discharged to a ground potential (VSS). The voltage at the SN determines the gate voltage of the read transistor Tr. After the voltage is written to the SN, a low potential may be applied to the WWL to turn off the write transistor Tw. Thus, the charge remains at the SN due to the parasitic capacitance at the SN and the voltage potential is stored by the SN.

In an embodiment, in a read operation, the WWL may be supplied with a low potential and the write transistor Tw may be turned off. In an embodiment, a voltage, such as VDD or VSS, may be applied to the RBL to pre-charge the RBL to the voltage (e.g., VDD or VSS), and the voltage potential in the SN may be read on the RWL. For example, if the SN stores a voltage potential that is high, the read transistor Tr turns on and a first level may be sensed on the RWL, and if the SN stores a voltage potential that is a low potential, the read transistor remains off and a second level may be sensed on the RWL. While the above write and read operations are described with reference to a high potential being used to turn on the write transistor Tw and the read transistor Tr, this description is only an example and, in some embodiments, a low potential may be used to turn on the write transistor Tw and the read transistor Tr.

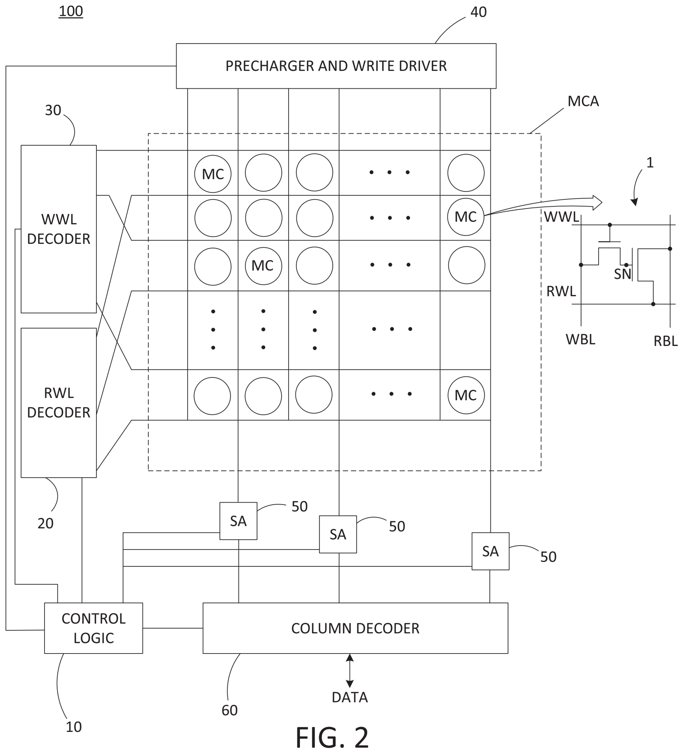

FIG. 2 illustrates a semiconductor memory device, according to some embodiments. According to an embodiment, a semiconductor memory device 100 may include a memory cell array (MCA), control logic 10, a RWL decoder 20, a WWL decoder 30, a precharger and write driver 40, a plurality of sense amplifiers (SA) 50, and a column decoder 60. The MCA may include a plurality of memory cells (MC) that are arranged in a grid structure. In an embodiment, each of the MCs may be the 2T0C gain cell 1 as illustrated in FIG. 1. In an embodiment, each of the MCs may be disposed in a BEOL stacked structure as described herein. Each of the MCs may be electrically connected to the RWL decoder 20 through a corresponding RWL, electrically connected to the WWL decoder 30 through a corresponding WWL, electrically connected to the precharger and write driver 40 through a corresponding RBL and a corresponding RBL, and a corresponding one of the plurality of sense amplifiers 50 through a corresponding RBL. The plurality of sense amplifiers 50 may be electrically connected to the column decoder 60.

The control logic 10 may control each of the RWL decoder 20, the WWL decoder 30, the precharger and write driver 40, the plurality of SAs 50, and the column decoder 60, based on one or more control signals received from outside the semiconductor memory device 100.

The RWL decoder 20 may receive a read word line control signal from the control logic 10, and based on the read word line control signal, may apply a voltage potential to one of the plurality of RWLs.

The WWL decoder 30 may receive a write word line control signal from the control logic 10, and based on the write word line control signal, may apply a voltage potential to one of the plurality of RWLs.

The precharger and write driver 40 may receive a precharge control signal from the control logic 10, and based on the precharge control signal, may precharge one or more of the RBLs. The precharger and write driver 40 may receive a write control signal from the control logic 10, and based on the write control signal, may assert or de-assert one of the WBLs.

The plurality of SAs 50 may sense stored data from one of the SNs of the MCs by control of the control logic 10, may amplify the data, and output the data to the column decoder 60. The column decoder 60 may receive a column control signal from the control logic 10 and may output data (DATA) to an outside of the semiconductor memory device 100.

In an embodiment, in a write operation of a MC, the control logic 10 may control the RWL decoder 20 and the precharger and write driver 40 to apply a low potential to the RWL and the RBL of one of the MCs to turn off the read transistor Tr of the memory cell MC. The control logic 10 may control the WWL decoder 30 to apply a high potential to a WWL of the MCs to turn on the write transistor Tw of the MC. The control logic 10 may control the precharger and write driver 40 to provide a high potential or low potential to the WBL of the MC according to data to be written to the MC, and a voltage corresponding to data to be written is stored in the SN. For example, in an embodiment, if the control logic 10 controls the precharger and write driver 40 to assert the WBL of the MC, the storage node SN of the memory cell MC is charged to VDD, and if the control logic 10 controls the precharger and write driver 40 to apply a low potential to the WBL, the SN of the MC is discharged to VSS. After the voltage is written to the SN of the MC, the control logic 10 controls the WWL decoder 30 to apply a low potential to the WWL of the write transistor Tw of the MC. Thus, the charge remains at the SN of the MC due to the parasitic capacitance at the SN and the voltage potential is stored by the SN of the MC. The write operation is described for one MC of the plurality of MCs. However, the operation of the write operation with respect to the remainder of the MC is the same and repeated description thereof is omitted for conciseness.

In an embodiment, in a read operation of the MC, the control logic 10 controls the WWL decoder 30 to apply a low potential to the WWL of the MC to turn off the write transistor Tw of the MC. The control logic 10 may control the RWL decoder 20 to apply VDD or VSS to the RWL of the MC to pre-charge the RWL to VDD or VSS and the data stored in the SN of the MC may be read on the RBL of the MC by the corresponding sense amplifier 50. For example, if the SN of the MC stores a high potential, the read transistor Tr turns on and a first level may be sensed on the RBL by the sense amplifier 50, and if the storage node SN stores a low potential, the read transistor remains off and a second level may be sensed on the RBL by the sense amplifier 50. The read operation is described for one MC of the plurality of MCs. However, the read operation with respect to the remainder of the MCs is the same and repeated description thereof is omitted for conciseness.

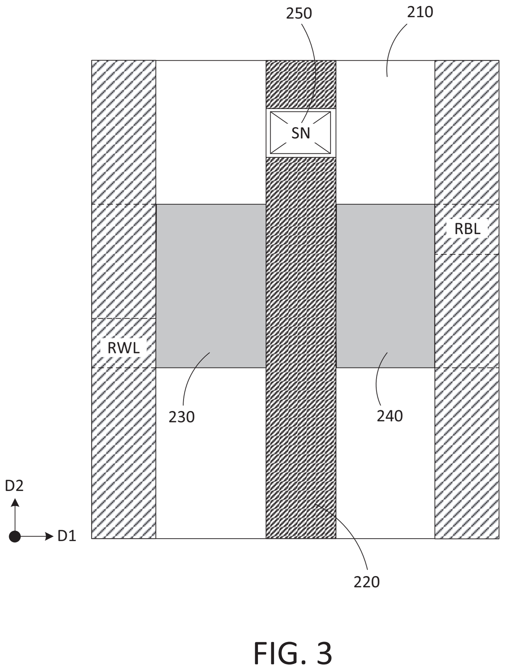

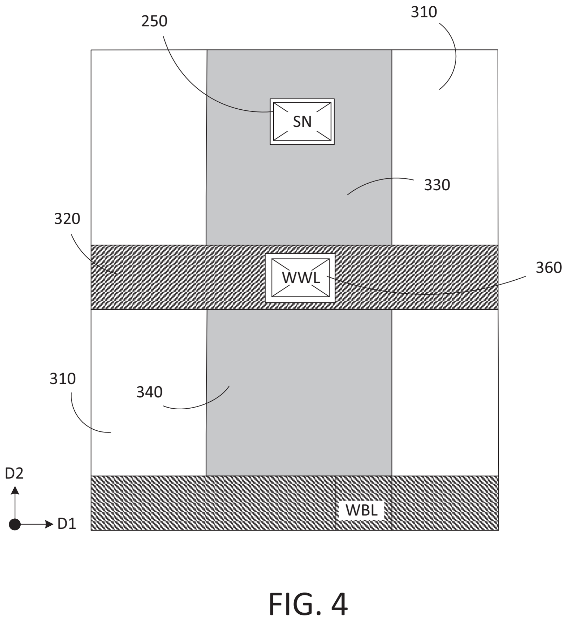

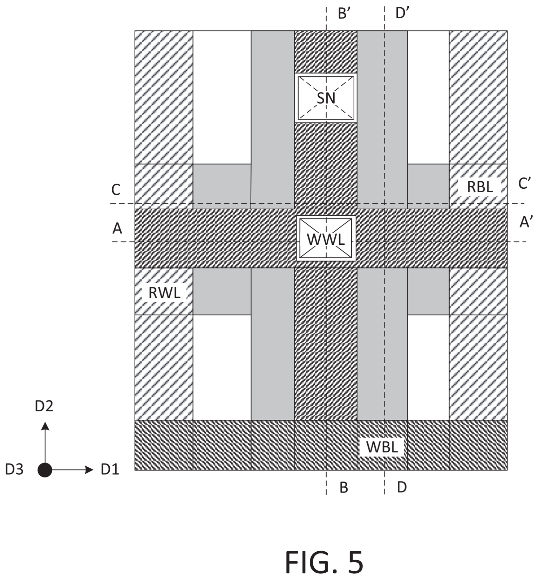

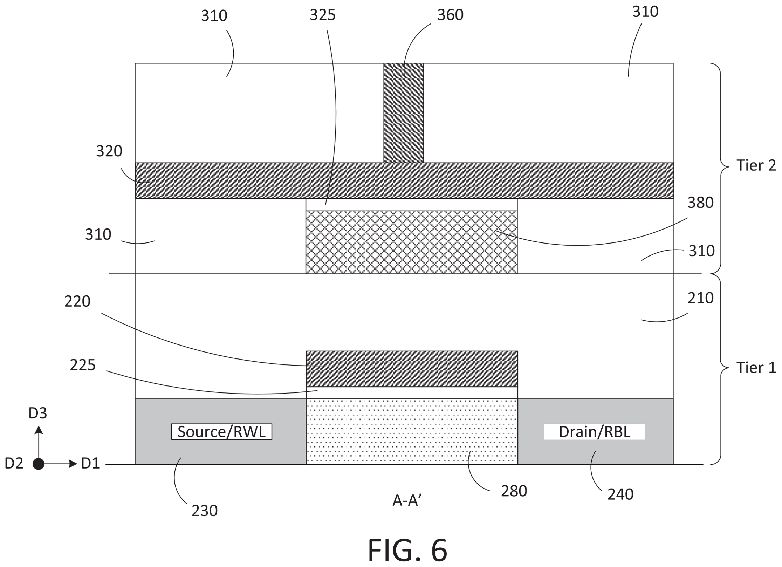

FIGS. 3 and 4 illustrate plan views of tiers of an exemplary layout of the 2T0C gain cell of FIG. 1, according to some embodiments. FIG. 5 illustrates a plan view of an exemplary composite layout of the 2T0C gain cell of FIG. 1, according to some embodiments. For example, FIG. 5 illustrates a plan view of a composite layout that combines the tiers illustrated in FIGS. 3 and 4. FIGS. 6 to 9 illustrate cross-sectional views taken along lines A-A', B-B', C-C', and D-D' in FIG. 5, respectively, according to some embodiments. With reference to FIGS. 1 and 6, in an embodiment, the 2T0C gain cell 1 may be formed in a stacked structure. In an embodiment, the stacked structure may be a BEOL stacked structure that is compatible with a BEOL process. For example, as described above, in a BEOL structure of a semiconductor memory device, a plurality of tiers may be formed. In an embodiment, each of the plurality of tiers may include an insulating layer and a transistor formed in the insulating layer. Each tier may be a transistor tier formed using a low temperature process (e.g., a BEOL process that uses temperatures less than about 400° C).

In an embodiment, the plurality to tiers may include a first tier (Tier 1) and a second tier (Tier 2). In an embodiment, as illustrated in FIG. 6, the Tier 1 may include an insulating layer 210, a gate line 220, a gate insulating layer 225, a first source/drain region 230, a second source/drain region 240, and a channel region 280. In an embodiment, the gate line 220, the first source/drain region 230, and the second source/drain region 240 may correspond respectively to the gate, the first source/drain, and the second source/drain of the read transistor Tr illustrated in FIG. 1.

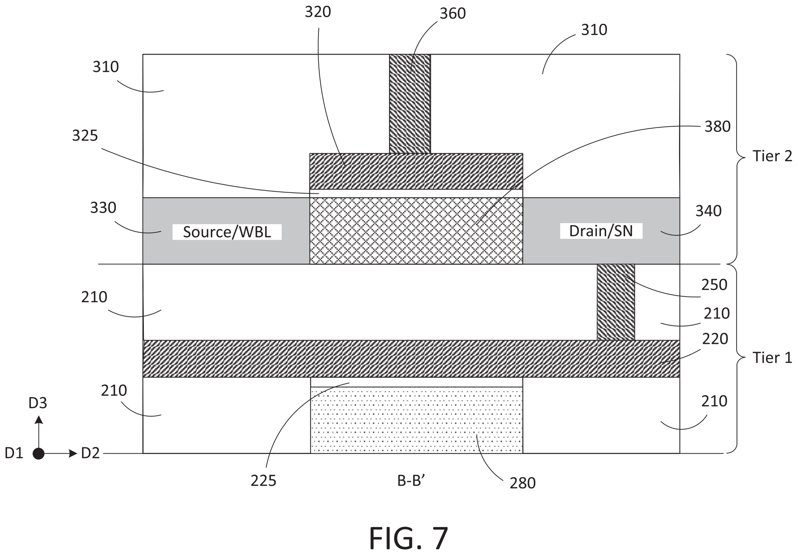

In an embodiment, the gate line 220, the gate insulating layer 225, the first source/drain region 230, the second source/drain region 240, and the channel region 280 may be disposed in the insulating layer 210. In an embodiment, as illustrated in FIG. 6, the channel region 280 may be disposed between the first source/drain region 230 and the second source/drain region 240 in a first direction D1. In an embodiment, as illustrated in FIG. 7, sidewalls of the channel region 280 in a second direction D2 may be surrounded by the insulating layer 210. As used in this specification, the first direction D1 may intersect the second direction D2, and a third direction D3 may be orthogonal to each of the first direction D1 and the second direction D2. The third direction D3 may also be referred to as a vertical direction.

In an embodiment, as illustrated in FIGS. 6 and 7, the gate line 220 may be disposed on the channel region 280 in the third direction D3. In an embodiment, the gate line 220 may completely cover the channel region 280 in the first direction D1. The gate line 220 may be disposed over the channel region 280 with the gate insulating layer 225 between the gate line 220 and the channel region 280 in the third direction D3. In an embodiment, the gate line 220 may contact the gate insulating layer 225, and the gate insulating layer 225 may contact the channel region 280. The gate line 220, the gate insulating layer 225, the first source/drain region 230, the second source/drain region 240 and the channel region 280 may each extend in the second direction D2. In an embodiment, top surfaces of the gate line 220, the first source/drain region 230, and the second source/drain region 240 may be covered by the insulating layer 210.

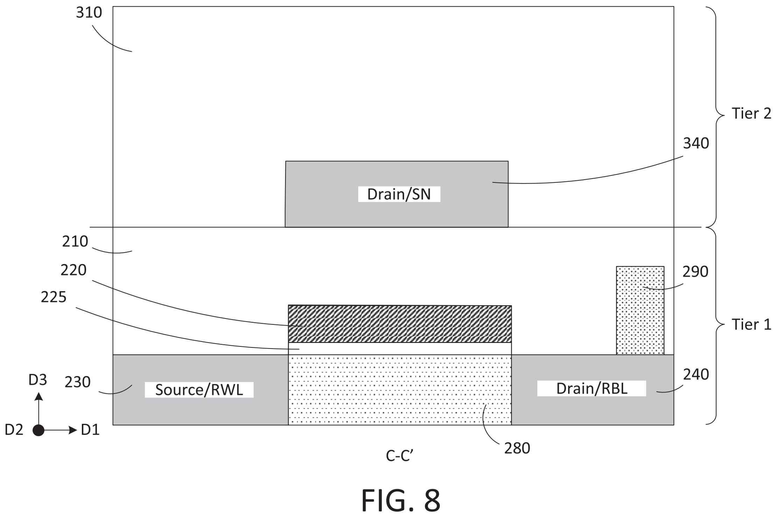

In an embodiment, as illustrated in FIG. 8, a via 290 may extend through the insulating layer 210 to connect the second source/drain region 240 to the RBL. In an embodiment, the RBL may be directly connected to the second source/drain region 240 by the via 290. In some embodiments, a wiring pattern may be connected to the via 290 in order to connect to the RBL.

In an embodiment, the channel region 280 may be a region between the first source/drain 230 and the second source/drain 240 and may be included in an active region in which the gate line 220 and the first and second source/drains 230 and 240 of the read transistor Tr are formed. In an embodiment, the channel region 280 may include polysilicon (poly-Si). For example, the poly-Si may be a low temperature poly-Si which is compatible with a BEOL process which uses low temperatures (e.g., less than about 400° C) that are lower than the comparatively high temperatures (e.g., greater than 1000 ° C) used in a FEOL process.

Continuing to refer to FIGS. 1 and 6, in an embodiment, the Tier 2 may be disposed on the Tier 1. For example, the Tier 2 may be disposed on the insulating layer 210 of the Tier 1. In an embodiment, the Tier 2 may overlap the Tier 1 in the third direction D3. In an embodiment, as illustrated in FIG. 6, the Tier 2 may include an insulating layer 310, a gate line 320, a gate insulating layer 325, a first source/drain region 330, a second source/drain region 340, and a channel region 380.

In an embodiment, the gate line 320, the first source/drain region 330, and the second source/drain region 340 may correspond respectively to the gate, the first source/drain, and the second source/drain of the write transistor Tw illustrated in FIG. 1.

In an embodiment, the gate line 320, the gate insulating layer 325, the first source/drain region 330, the second source/drain region 340, and the channel region 380 may be disposed in the insulating layer 310. In an embodiment, as illustrated in FIG. 7, the channel region 380 may be disposed between the first source/drain region 330 and the second source/drain region 340 in the second direction D2.

In an embodiment, as illustrated in FIG. 7, the gate line 320 may be disposed on the channel region 380 in the third direction D3. In an embodiment, the gate line 320 may completely cover the channel region 380 in the second direction D2. The gate line 320 may be disposed over the channel region 380 with the gate insulating layer 325 disposed between the gate line 320 and the channel region 380 in the third direction D3. In an embodiment, the gate line 320 may contact the gate insulating layer 325, and the gate insulating layer 325 may contact the channel region 380. The gate line 320, the gate insulating layer 325, the first source/drain region 330, the second source/drain region 340 and the channel region 380 may each extend in the second direction D1. In an embodiment, as illustrated in FIG. 7, top surfaces of the gate line 320, the first source/drain region 330, and the second source/drain region 340 may be covered by the insulating layer 310. In an embodiment, as illustrated in FIG. 7, a via 360 may extend through the insulating layer 310 to electrically connect the WWL to the gate line 320. In an embodiment, the WWL may be directly connected to the gate line 320 through the via 360. As illustrated in FIG. 7, the second source/drain region 340 of the write transistor Tw may be electrically connected to the gate line 220 of the read transistor Tr by a via 250. In an embodiment, the via 250 may directly connect to the second source/drain region 340 of the write transistor Tw and directly connect to the gate line 220 of the read transistor Tr.

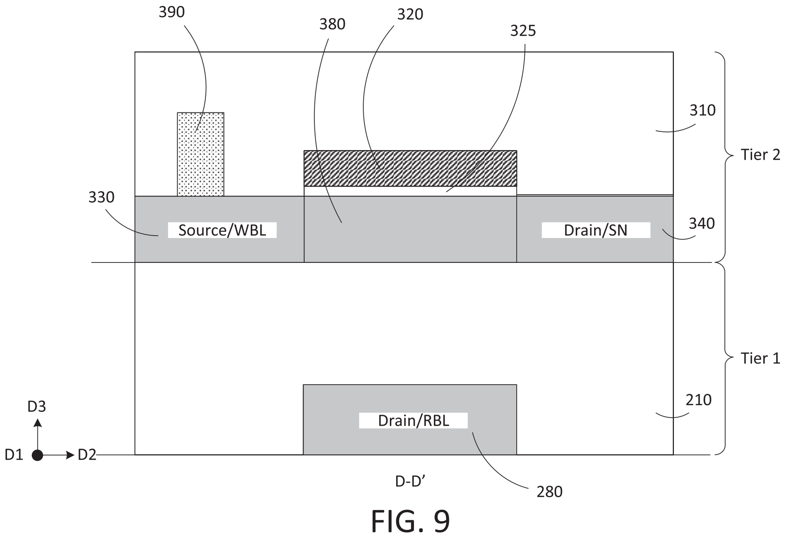

In an embodiment, as illustrated in FIG. 9, a via 390 may extend through the insulating layer 310 to connect the first source/drain region 330 to the WBL. In an embodiment, the WBL may be directly connected to the first source/drain region 330 by the via 390. In some embodiments, a wiring pattern may be connected to the via 390 in order to connect to the WBL.

In an embodiment, the channel region 380 may include an oxide semiconductor. For example, the oxide semiconductor may be selected from, but is not limited to, IGZO (InGaZnO), Sn-IGZO, IWO (InWO), IZO (InZnO), ZTO (ZnSnO), ZnO, YZO (yttrium-doped zinc oxide), IGSO (InGaSiO), InO, SnO, TiO, ZnON, MgZnO, ZrInZnO, HfInZnO, SnInZnO, AlSnInZnO, SiInZnO, AlZnSnO, GaZnSnO, or ZrZnSnO, or a combination thereof.

In an embodiment, the channel region 380 may be a region between the first source/drain 330 and the second source/drain 340 and may be included in an active region in which the gate line 320 and the first and second source/drains 330 and 340 of the write transistor Tw are formed. In an embodiment, the channel region 380 may be perpendicular to the channel region 280 in plan view, as best seen in FIGS. 3-5.

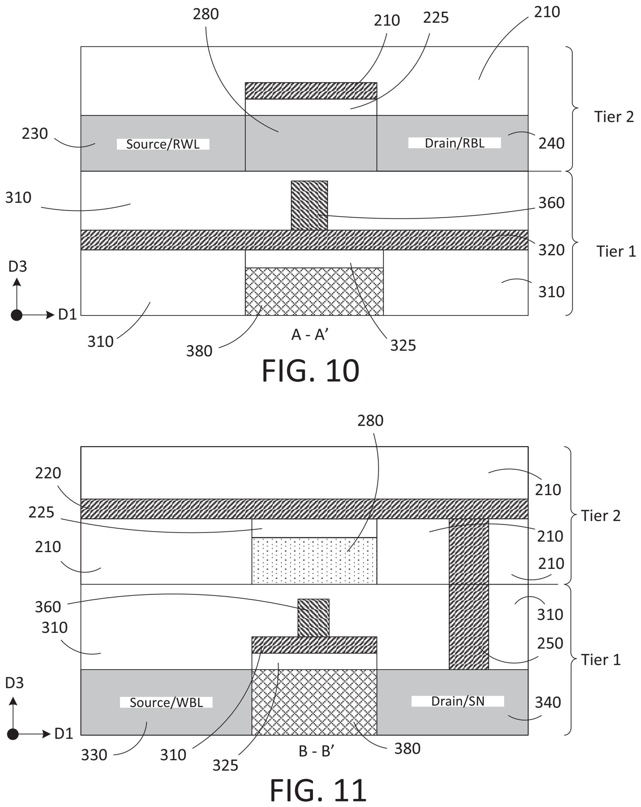

FIG. 10 illustrates a plan view of tiers of an exemplary layout of the 2T0C gain cell of FIG. 1, taken along A-A' in FIG. 5, according to some embodiments. FIG. 11 illustrates a plan view of tiers of an exemplary layout of the 2T0C gain cell of FIG. 1, taken along B-B' in FIG. 5. FIGS. 10 and 11 correspond to the cross-sectional views illustrated in FIGS. 6 and 7, respectively, except that the components of the read transistor Tr are implemented in the Tier 2 and the components of the write transistor Tw are implemented in the Tier 1. In an embodiment, the Tier 2 may vertically overlap the Tier 1 in the third direction D3. In FIG. 10, like reference designators refer to like components in FIG. 6 and in FIG. 11, like reference designators refer to like components in FIG. 7, and repeated description thereof is omitted for conciseness.

As illustrated in FIG. 10, the first source/drain region 230, the channel region 280, and the second source/drain region 240 of the read transistor Tr may be disposed on the insulating layer 310. Unlike in the stacked structure of FIG. 6, the via 250 may extend from the bottom of the gate line 220 of the read transistor Tr to the top of the second source/drain region 340 of the write transistor Tw.

In an embodiment, a plurality of read transistors Tr may be arranged in Tier 1 and spaced apart from each other in both the first direction D1 and the second direction D2, and a plurality of write transistors Tw may be arranged in the Tier 2 and spaced apart from each other in both the first direction D1 and the second direction D2 and stacked on top of the read transistors Tr, respectively, in order to achieve the MCs arranged in the grid structure of the MCA illustrated in FIG. 2. In other words, the read transistor Tr of the Tier 1 and the write transistor Tw of the Tier 2 may each be repeated in both the first direction D1 and the second direction D2 to realize the MCA illustrated in FIG. 2.

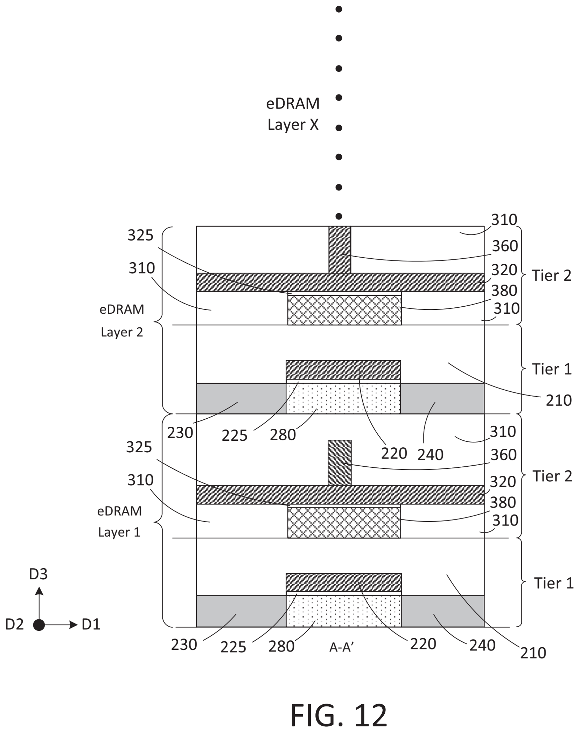

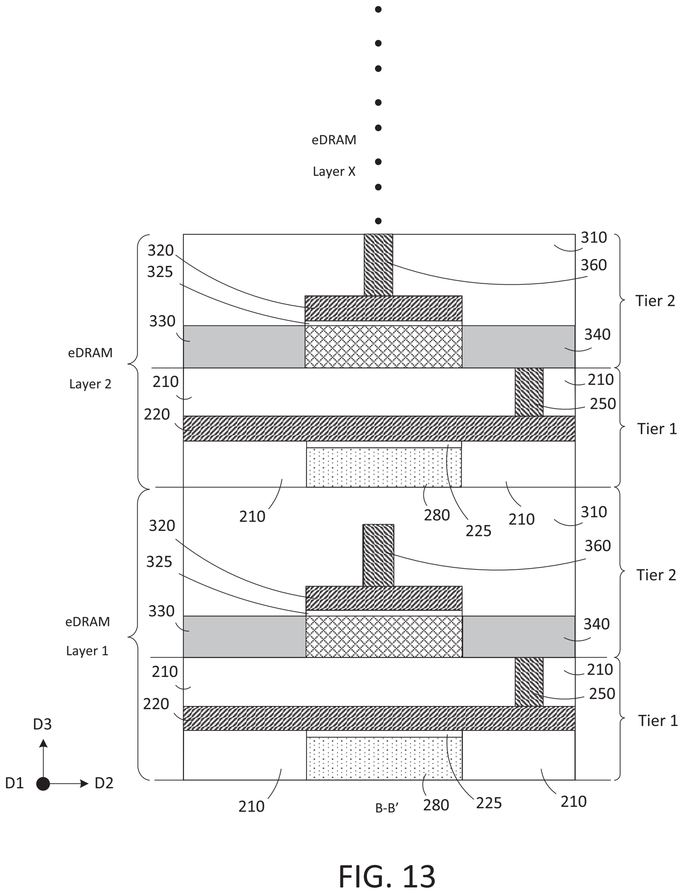

FIG. 12 illustrates a cross-sectional view of an example of an eDRAM, taken along A-A' in FIG. 5, according to some embodiments. FIG. 13 illustrates a cross-sectional view of an example of the eDRAM, taken along B-B' in FIG. 5, according to some embodiments. FIGS. 12 and 13 correspond to the cross-sectional views illustrated in FIGS. 6 and 7, respectively. In FIG. 12, like reference designators refer to like components in FIG. 6, and in FIG. 13, like reference designators correspond to like components in FIG. 7, and repeated description thereof is omitted for conciseness. In an embodiment, the eDRAM may include a plurality of eDRAM layers stacked in the third direction D3. For example, the plurality of eDRAM layers may include a first eDRAM layer (eDRAM Layer 1), a second eDRAM layer (eDRAM Layer 2), ..., to an X-th eDRAM layer (eDRAM Layer X) that are stacked in the third direction D3. Each of eDRAM Layer 1, eDRAM Layer 2, ..., to eDRAM Layer X may include the BEOL stacked structure illustrated in FIGS. 6-9. For example, in an embodiment, the eDRAM Layer 1 may include the Tier 1 implementing the read transistor Tr illustrated in FIG. 1 and the Tier 2 implementing the write transistor Tw illustrated in FIG. 1, and the Tier 2 may be stacked on top of the Tier 1 in the third direction D3, as illustrated in FIG. 6. The eDRAM Layer 2 may include the Tier 1 implementing the read transistor Tr illustrated in FIG. 1 and the Tier 2 implementing the write transistor Tw illustrated in FIG. 1, and the Tier 2 may be stacked on top of the Tier 1, as illustrated in FIG. 6. The eDRAM Layer X may include the Tier 1 implementing the read transistor Tr illustrated in FIG. 1 and the Tier 2 implementing the write transistor Tw illustrated in FIG. 1, and the Tier 2 may be stacked on top of the Tier 1, as illustrated in FIG. 6. In some embodiments, one or more of the plurality of layers may have a BEOL stacked structure with the Tier 1 implementing the write transistor Tw illustrated in FIG. 1 and the Tier 2 implementing the read transistor Tr illustrated in FIG. 1, with the Tier 2 stacked on top of the Tier 1 as illustrated in FIG. 10. In some embodiments, each of the plurality of eDRAM layers may have a BEOL stacked structure with the Tier 1 implementing the write transistor Tw and the Tier 2 implementing the read transistor Tr, with the Tier 2 stacked on top of the Tier 1 as illustrated in FIG. 10.

In an embodiment, a plurality of read transistors Tr may be arranged the Tier 1 and spaced apart from each other in both the first direction D1 and the second direction D2, and a plurality of write transistors Tw may be arranged in the Tier 2 and spaced apart from each other in both the first direction D1 and the second direction D2 and stacked on top of the read transistors Tr, respectively, in order to achieve the MCA illustrated in FIG. 2.

In an embodiment, each of the eDRAM Layer 1, eDRAM Layer 2, ..., to eDRAM Layer X may include a plurality of read transistors Tr arranged in the Tier 1 and spaced apart from each other in both the first direction D1 and the second direction D2, and a plurality of write transistors Tw arranged in the Tier 2 and spaced apart from each other in both the first direction D1 and the second direction D2 and stacked on top of the read transistors Tr, respectively, in order to achieve a 3D arrangement of the memory cells MC in the MCA illustrated in FIG. 2.

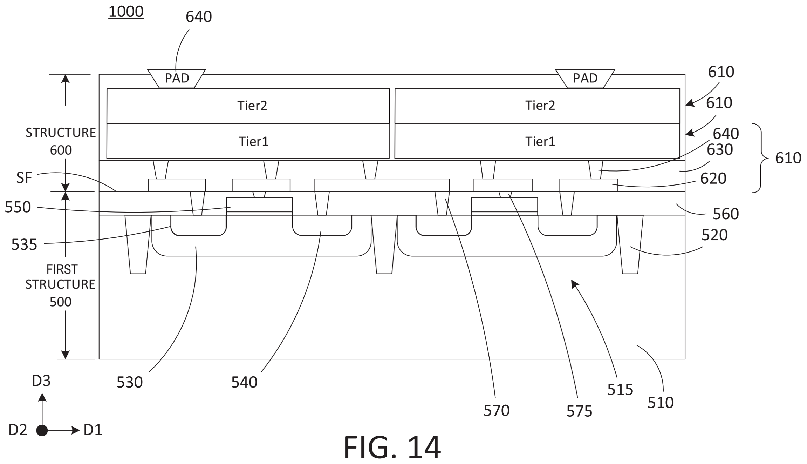

FIG. 14 illustrates a cross-sectional view of an example of a semiconductor memory device, according to some embodiments.

In an embodiment, a semiconductor memory device 1000 may include a first structure 500 and a second structure 600. The first structure 500 may have a top surface (SF), and the second structure 600 may be disposed on top surface (SF) of the first structure 500. In an embodiment, the first structure 500 may be FEOL compatible such that the first structure 500 may be fabricated using a FEOL process at a temperature of, for example, greater than 1000 ° C. In an embodiment, the second structure 600 may be BEOL compatible such that the second structure 600 may be fabricated using a BEOL process at a temperature of, for example, less than about 400 ° C.

In an embodiment, the first structure 500 may include a substrate 510 and an upper dielectric layer 560 on top of the substrate 510. The substrate 510 may be a silicon substrate and may include a plurality of PMOS transistors 515 in the substrate 510 that are separated by shallow trench isolation (STI) structures 520. Each PMOS transistor 515 may include a P well 530. The P well may have N-doped regions 535 and 540 therein as a source and drain of the PMOS transistor 515. A gate 550 may be disposed on the P well 530. A plurality of vias 570 may be disposed on gate 550 and the N-doped wells 535 to extend to the top surface SF of the FEOL structure 500. However, the first structure 500 is merely an example and, in some embodiments, the first structure 500 may be configured differently as long as the first structure includes one or more transistors. In some embodiments, the one or more transistors may be included in one or more logic chips.

The second structure 600 may include a plurality of connection layers 610. One or more of the plurality of connection layers 610 may include an insulating layer 620, one or more wiring patterns 630, and one or more vias 640. The plurality of connection layers 610 may include the stacked structure that is BEOL compatible as described above. For example, one of the plurality of connection layers 610 may include a read transistor Tr illustrated in FIG. 1 in the Tier 1 and another of the plurality of connection layers 610 may include a write transistor Tw illustrated in FIG. 1 in the Tier 2 according to the embodiments of FIGS. 1 and 6 described above. In some embodiments, one of the plurality of connection layers 610 may include a write transistor Tw illustrated in FIG. 1 in the Tier 1 and another of the plurality of connection layers 610 may include a read transistor Tr illustrated in FIG. 1 in the Tier 2 according to the embodiments of FIGS. 1 and 10 described above.

According to various embodiments, a hybrid 2T0C gain cell may include an OS based write transistor stacked with a polysilicon based read transistor to form a stacked structure, where the stacked structure is compatible with a BEOL process. In some embodiments, a plurality of the hybrid 2T0C gain cells may be repeatedly stacked to form a 3D embedded DRAM with monolithic integration. Various embodiments provide a high density memory, that is fully BEOL compatible and that provides increase reliability.

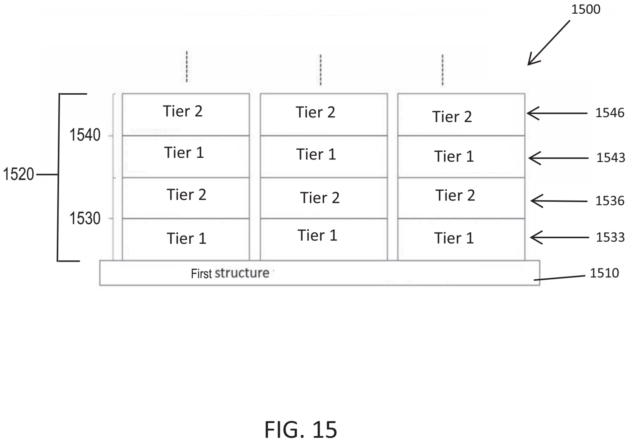

FIG. 15 illustrates system having monolithic integration, according to some embodiments. In an embodiment, a system 1510 may implement a 3D eDRAM. In an embodiment, the system 1500 may be implemented as a single chip. In an embodiment, the system 1500 may include a first structure 1510 and a second structure 1520. In an embodiment, the second structure 1520 may include a plurality of 2T0C gain cells as illustrated and described with respect to FIGS. 1 and 6. For example, in some embodiments, the second structure 1520 may include a plurality of the eDRAM structures illustrated and described with respect to FIGS. 12 and 13 that are spaced apart in a direction that is parallel to the first structure 1510. In an embodiment, the second structure 1520 may include a first eDRAM layer 1530 and a second eDRAM layer 1540. While two eDRAM layers are illustrated in FIG. 15, embodiments are not limited to two eDRAM layers and, in some embodiments, a plurality of eDRAM layers may be provided, as illustrated by the dotted lines in FIG. 15.

In an embodiment, the first structure 1510 may be a FEOL structure that is FEOL compatible such that the first structure 1510 may be fabricated using a FEOL process at a temperature of, for example, greater than about 1000 °C. The first structure 1510 may include one or more transistors. In an embodiment, the first structure 1510 may include one or more logic chips. For example, one or more logic chips may include one or more transistors.

In an embodiment, the second structure 1520 may be may be a BEOL structure that is BEOL compatible such that the second structure 1520 may be fabricated using a BEOL process at a temperature of, for example, less than about 400 °C. The first eDRAM layer 1530 may be on a top surface of the first structure 1510, and the second eDRAM layer 1540 may be on a top surface of the first eDRAM layer 1530. In an embodiment, the first eDRAM layer 1530 may be formed on the first structure 1510, and the second eDRAM layer 1540 may be formed on the first eDRAM layer 1530. In some embodiments, the first eDRAM layer 1530 may be hybrid bonded to the first structure 1510, and the second eDRAM layer 1540 may be hybrid bonded to the first eDRAM layer 1530.

In an embodiment, the first eDRAM layer 1530 may include a first layer 1533 on the first structure 1510 and a second layer 1536 on the first layer 1533. In an embodiment, as illustrated in FIG. 15, the first layer 1533 may be on the top surface of the first structure 1510. In an embodiment, the first layer 1533 may include a plurality of the Tier 1. For example, each of the Tier 1 may include the read transistor Tr illustrated and described with respect to FIGS. 1 and 6. In an embodiment, the plurality of Tier 1 of the first layer 1533 may be spaced apart from each other in a direction that is parallel to the top surface of the first structure 1510, as illustrated in FIG. 15. In an embodiment, the second layer 1536 may include a plurality of the Tier 2 respectively on the plurality of the Tier 1 of the first layer 1533. For example, each of the Tier 2 may include the write transistor Tw illustrated and described with respect to FIGS. 1 and 6. In an embodiment, the plurality of the Tier 2 may be spaced apart from each other in the direction that is parallel to the top surface of the first structure 1510, as illustrated in FIG. 15. In an embodiment, a combination of one of the plurality of Tier 1 of the first layer 1533 and one of the plurality of Tier 2 of the second layer 1536 may correspond to the 2T0C gain cell 1 of FIG. 1 formed in the stacked structure illustrated in FIG. 6. In other words, the first eDRAM layer 1530 may include a plurality of 2T0C gain cells 1 spaced apart from each other in the direction that is parallel to the top surface of the first structure 1510. While FIG. 15 illustrates the 2T0C gain cells 1 of the first eDRAM layer 1530 having the stacked structure according to FIG. 6, this stacked structure is only an example and, in some embodiments, the system may include 2T0C gain cells 1 in the stacked structure illustrated and described with respect to FIG. 10.

The second eDRAM layer 1540 may include a first layer 1543 and a second layer 1546. The first layer 1543 of the second eDRAM layer 1540 may be on the second layer 1536 of the first eDRAM layer 1530. In an embodiment, as illustrated in FIG. 15, the first layer 1543 of the second eDRAM block 1540 may be on the top surface of the second layer 1536 of the first eDRAM block 1530. In an embodiment, the first layer 1543 may include a plurality of the Tier 1. For example, each of the Tier 1 may include the read transistor Tr illustrated and described with respect to FIGS. 1 and 6. In an embodiment, the plurality of the Tier 1 of the first layer 1543 may be spaced apart from each other in a direction that is parallel to the top surface of the first structure 1510, as illustrated in FIG. 15. In an embodiment, the second layer 1546 may include a plurality of the Tier 2 respectively on the plurality of the Tier 1 of the first layer 1543. For example, each of the Tier 2 may include the write transistor Tw illustrated and described with respect to FIGS. 1 and 6. In an embodiment, the plurality of Tier 2 may be spaced apart from each other in the direction that is parallel to the top surface of the first structure 1510, as illustrated in FIG. 15. In an embodiment, a combination of one of the Tier 1 of the first layer 1543 and one of the plurality of Tier 2 of the second layer 1546 may correspond to the 2T0C gain cell 1 of FIG. 1 formed in the stacked structure illustrated in FIG. 6. In other words, the second eDRAM layer 1540 may include a plurality of 2T0C gain cells 1 spaced apart from each other in the direction that is parallel to the top surface of the first structure 1510. While FIG. 15 illustrates the 2T0C gain cells 1 in the second eDRAM layer 1540 having the stacked structure according to FIG. 6, this stacked structure is only an example and, in some embodiments, the system may include 2T0C gain cells 1 in the stacked structure illustrated and described with respect to FIG. 10.

As discussed above, in an embodiment, the first eDRAM layer 1530 may be hybrid bonded to the first structure 1510 such that the first layer 1533 is hybrid bonded to the first structure 1510. In an embodiment, the second eDRAM layer 1540 may be hybrid bonded to the first eDRAM layer 1530 such that the first layer 1543 of the second eDRAM layer 1540 is hybrid bonded to the second layer 1536 of the first eDRAM layer 1530.

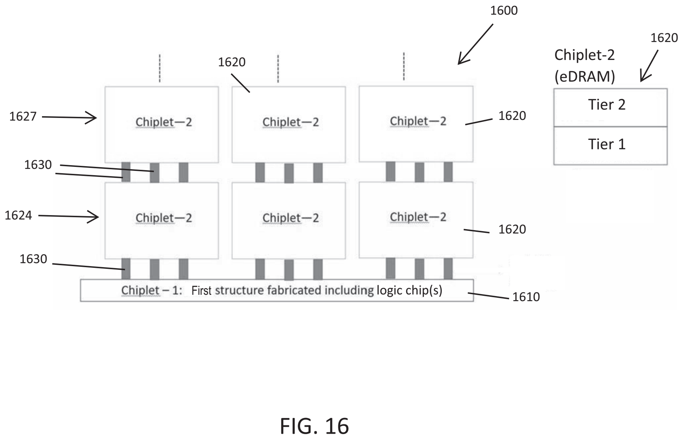

FIG. 16 illustrates a system having heterogeneous integration, according to some embodiments. In an embodiment, the system 1600 may be a 3D eDRAM and may include a first chiplet (Chiplet-1) 1610 and a plurality of second chiplets (Chiplet-2) 1620. In an embodiment, the Chiplet-1 1610 may be a FEOL structure that is fabricated in a FEOL process. In an embodiment, the Chiplet-1 1610 may include one or more transistors. In an embodiment, the Chiplet-1 1610 may include one or more logic chips. For example, one or more logic chips may include one or more transistors.

In an embodiment, the plurality of Chiplet-2 1620 may be fabricated separately from the fabrication of the Chiplet-1 1610. In an embodiment, each of the plurality of Chiplet-2 1620 may be a BEOL structure that is fabricated in a BEOL process. In an embodiment, each of the plurality of Chiplet-2 1620 may be fabricated separately from the fabrication of the Chiplet-1 1610. In an embodiment, each of plurality of Chiplet-2 1620 may be fabricated separately from each other.

In an embodiment, the plurality of Chiplet-2 1620 may be arranged in a first row 1624 on the Chiplet-1 1610 and may be spaced apart in a first direction that is parallel to a top surface of the hiplet-1) 1610. In an embodiment, the plurality of Chiplet-2 1620 may be further arranged in a second direction that is parallel to the top surface of the Chiplet-1 1610 and that intersects the first direction, and may be spaced apart from each other in the second direction. In an embodiment, each of the plurality of Chiplet-2 1620 in the first row 1624 may have a hybrid bond 1630 with the Chiplet-1 1610.

In some embodiments, the plurality of Chiplet-2 1620 may be arranged in a second row 1627 to correspond respectively to the plurality of Chiplet-2 1620 in the first row 1624 and may be spaced apart in the first direction and/or the second direction. In other words, the plurality of Chiplet-2 1620 may be stacked in a third direction that is orthogonal to the first direction and the second direction to form the 3D eDRAM structure. In an embodiment, the plurality of Chiplet-2 in the second row 1627 may each have a hybrid bond 1630 with corresponding ones of the plurality of Chiplet-2 1620 in the first row 1624, thus forming a 3D eDRAM having heterogeneous integration.

In an embodiment, each of the plurality of Chiplet-2 1620 may comprise the 2T0C gain cell 1 illustrated in FIGS. 1 and 6 and thus may include the Tier 1 having the read transistor Tr and the Tier 2 having the write transistor Tw on the Tier 1. While FIG. 16 illustrates the Chiplet-2 1620 having the 2T0C gain cell 1 with the stacked structure illustrated and described with respect to FIG. 6, this stacked structure is only an example and, in some embodiments, the Chiplet-2 1620 may include the 2T0C gain cell 1 with the stacked structure illustrated and described with respect to FIG. 10.

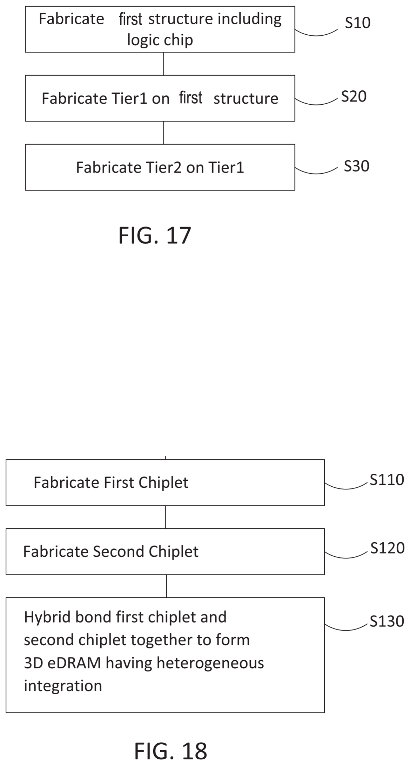

FIG. 17 illustrates a flowchart showing a method of manufacturing an eDRAM, according to some embodiments. In an embodiment, the method of manufacturing the eDRAM may include operations S10 to S30. In an embodiment, the method of manufacturing the eDRAM may be used to manufacture the 3D eDRAM having monolithic integration illustrated in FIG. 15.

In operation S10, a first structure may be fabricated. For example, in an embodiment, the first structure may be fabricated using a FEOL process. The FEOL process may be performed at a temperature of greater than about 1000 °C. The first structure may correspond to the first structure 500 illustrated in FIG. 14, the first structure 1500 illustrated in FIG. 15, or the Chiplet-1 of FIG. 16. In an embodiment, the first structure may include one or more transistors. In an embodiment, the first structure may include one or more logic chips. For example, one or more logic chips may include one or more transistors.

In operation S20, a Tier 1 may be fabricated on the first structure. In an embodiment, the Tier 1 may be fabricated using a BEOL process. The BEOL process may be performed at a temperature of less than about 400 °C. For example, the Tier 1 may be the Tier 1 illustrated and described with respect to FIGS. 1 and 6 or the Tier 1 illustrated and described with respect to FIGS. 1 and 10. In some embodiments, the Tier 1 may correspond to the first layer 1533 illustrated in FIG. 15 and may include a plurality of the Tier 1, and fabricating the Tier 1 may include fabricating the plurality of the Tier 1 of the first layer 1533 on a top surface of the first structure 1510 in FIG. 15. In an embodiment, the plurality of Tier 1 may be spaced apart from each other in a direction that is parallel to the top surface of the first structure 1510 as illustrated in FIG. 15.

In operation S30, a Tier 2 may be fabricated on the first tier. In an embodiment, the Tier 2 may be fabricated using a BEOL process. The BEOL process may be performed at a temperature of less than about 400 °C. For example, the Tier 2 may be the Tier 2 illustrated and described with respect to FIGS. 1 and 6 or the Tier 2 illustrated and described with respect to FIGS. 1 and 10. In some embodiments, the Tier 2 may correspond to the second layer 1536 illustrated in FIG. 15 and include a plurality of the Tier 2 respectively on the plurality of the Tier 1 of the first layer 1533, and fabricating the Tier 2 may include fabricating the plurality of Tier 2 on the plurality of Tier 1, respectively, as illustrated in FIG. 15. In an embodiment, the plurality of Tier 2 may be spaced apart from each other in the direction that is parallel to the top surface of the first structure 1510 as illustrated in FIG. 15.

FIG. 18 illustrates a flowchart showing a method of manufacturing an eDRAM, according to some embodiments. In an embodiment, the method of manufacturing the eDRAM may include operations S110 to S130.

In operation S110, a first chiplet may be fabricated. In an embodiment, the first chiplet may correspond to the Chiplet-1 in FIG. 16. The first chiplet may be fabricated using a FEOL process. The FEOL process may be performed at a temperature of greater than about 1000 °C.

In operation S120, a second chiplet may be fabricated. In an embodiment, the second chiplet may correspond to the Chiplet-2 in FIG. 16 and may be fabricated as a separate chiplet from the first chiplet. In an embodiment, the second chiplet may be fabricated in a BEOL process. The BEOL process may be performed at a temperature of less than about 400 °C. For example, in some embodiments, the second chiplet may include the Tier 1 having the read transistor Tr and the Tier 2 having the write transistor Tw and may, for example, correspond to the Chiplet-2 illustrated and described with respect to FIG. 16. In some embodiments, the fabrication of the second chiplet may include fabricating a plurality of Chiplet-2, as discussed above with respect to FIG. 16.

In operation S130, the first chiplet and the second chiplet may be bonded together by hybrid bonding to form a 3D eDRAM having heterogeneous integration. .

### Exemplary Implementations

Various exemplary implementations are described with reference to the following numerical clauses.
1. A hybrid 2T0C gain cell eDRAM comprising a stack of tiers comprising a first tier and a second tier, wherein one of the first tier and the second tier in the hybrid 2T0C gain cell eDRAM comprises an oxide semiconductor as a write transistor and the other of the first tier and the second tier comprises polysilicon as a read transistor.
2. The hybrid 2T0C gain cell eDRAM of clause 1, wherein the first tier and the second tier repeat to form a 3D 2T0C gain cell eDRAM.
3. The hybrid 2T0C gain cell eDRAM of clause 1, wherein the first tier comprises the oxide semiconductor as the write transistor and the second tier comprises the polysilicon as the read transistor.
4. The hybrid 2T0C gain cell eDRAM of clause 1, wherein the first tier comprises the polysilicon as the read transistor and the second tier comprises the oxide semiconductor as the write transistor.
5. The hybrid 2T0C gain cell eDRAM of clause 1, wherein the oxide semiconductor comprises indium oxide.
6. The hybrid 2T0C gain cell eDRAM of clause 1, wherein the oxide semiconductor comprises indium tin oxide.
7. The hybrid 2T0C gain cell eDRAM of claim 1, wherein the oxide semiconductor comprises indium gallium zinc oxide.
8. The hybrid 2T0C gain cell eDRAM of claim 1, wherein the oxide semiconductor comprises tin oxide.
9. The hybrid 2T0C gain cell eDRAM of claim 1, wherein the oxide semiconductor comprises zinc oxide.
10. The hybrid 2T0C gain cell eDRAM of claim 1, wherein the oxide semiconductor comprises Si-doped indium oxide.
11. The hybrid 2T0C gain cell eDRAM of claim 1, wherein the oxide semiconductor comprises Ge-doped indium oxide.
12. The hybrid 2T0C gain cell eDRAM of claim 1, wherein the oxide semiconductor comprises W-doped indium oxide.
13. A structure comprising a first tier, and a second tier, wherein the second tier is stacked on top of the first tier and connected with storage nodes, the first tier comprises a read wordline, read bitline, a storage node, a gate metal, and a transistor channel, and the second tier comprises a write wordline, a write bitline, a storage node, a gate metal, and a transistor channel, the transistor channel in the first tier comprises polysilicon, the transistor channel in the second tier comprises oxide semiconductor, and the first tier and second tier transistor channels are perpendicular to each other.
14. The structure of clause 13, wherein the first tier and the second tier repeat to form a 3D 2T0C eDRAM.
15. A logic chip comprising a BEOL comprising the structure of clause 13, in which both the first tier and the second tier are fabricated and repeated.
16. A logic chip comprising the structure of clause 13, in which both the first tier and the second tier are fabricated as a separate chiplet and integrate with the logic chip through 3D heterogeneous integration.
17. A structure comprising a first tier, and a second tier, wherein the second tier is stacked on top of the first tier and connected with storage nodes, wherein the first tier comprises a write wordline, a write bitline, a storage node, a gate metal, and a transistor channel, and wherein the second tier comprises a read wordline, read bitline, a storage node, a gate metal, and a transistor channel, wherein the transistor channel in the first tier comprises oxide semiconductor, wherein the transistor channel in the second tier comprises polysilicon, wherein the first tier and second tier transistor channels are perpendicular to each other.
18. The structure of clause 17, wherein the first tier and the second tier repeat to form a 3D 2T0C eDRAM.
19. A logic chip comprising a BEOL comprising the structure of clause 17, in which both the first tier and the second tier are fabricated and repeated.
20. A logic chip comprising the structure of clause 17, in which both the first tier and the second tier are fabricated as a separate chiplet and integrate with the logic chip through 3D heterogeneous integration.
21. A hybrid 2T0C gain cell eDRAM comprising a stack of tiers comprising a first tier and a second tier, wherein one of the first tier and the second tier comprises an oxide semiconductor and the other of the first tier and the second tier comprises polysilicon.
22. The hybrid 2T0C gain cell eDRAM of clause 21, wherein the first tier and the second tier repeat to form a 3D 2T0C gain cell eDRAM.
23. A structure, comprising a first tier, and a second tier, wherein the second tier is stacked on top of the first tier and connected with storage nodes, wherein the first tier comprises a read wordline, read bitline, a storage node, a gate metal, and a transistor channel, and wherein the second tier comprises a write wordline, a write bitline, a storage node, a gate metal, and a transistor channel, wherein the transistor channel in the first tier comprises polysilicon, wherein the transistor channel in the second tier comprises oxide semiconductor, and wherein components of the first tier and second tier are perpendicular to each other.
24. The structure of clause 23, wherein the first tier and the second tier repeat to form a 3D 2T0C eDRAM.
25. The structure of clause 23 or 24, wherein both the first tier and the second tier are fabricated and repeated in a BEOL of a logic chip.
26. The structure of any of clauses 23-25, wherein both the first tier and the second tier are fabricated as separate chiplets and integrate with a logic chip through 3D heterogeneous integration.
31. A hybrid two transistor zero capacitor (2T0C) gain cell comprising a back end of line (BEOL) stacked structure including a first tier, and a second tier stacked on the first tier, wherein one of the first tier and the second tier comprises a write transistor having an oxide semiconductor channel and the other of the first tier and the second tier comprises a read transistor having a polysilicon channel.
32. The hybrid 2T0C gain cell according to clause 31, wherein the oxide semiconductor channel is perpendicular to the polysilicon channel in plan view.
33. The hybrid 2T0C gain cell according to clause 31 or 32, wherein the write transistor in the one of the first tier and the second tier is connected to the read transistor in the other of the first tier and the second tier by a storage node.
34. The hybrid 2T0C gain cell according to one of clauses 31 to 33, wherein the second tier vertically overlaps the first tier.
35. The hybrid 2T0C gain cell according to one of clauses 31 to 34, wherein the first tier comprises the write transistor, and the second tier comprises the read transistor.
36. The hybrid 2T0C gain cell according to one of clauses 31 to 35, wherein the first tier comprises the read transistor, and the second tier comprises the write transistor.
37. The hybrid 2T0C gain cell according to one of clauses 31 to 36, wherein the read transistor comprises a gate, a first source/drain, and a second source/drain, and the write transistor comprises a gate, a first source/drain, and a second source/drain, wherein the gate of the read transistor is electrically connected to the second source/drain of the write transistor.
38. The hybrid 2T0C gain cell according to one of clauses 31 to 37, wherein a gate line of the read transistor is connected to a second source/drain region of the write transistor through a via.
39. The hybrid 2T0C gain cell according to one of clauses 31 to 38, wherein a portion of the gate line of the read transistor in the first tier vertically overlaps a portion of the second source/drain region of the write transistor in the second tier, and the via vertically connects the portion of the gate line of the read transistor to the portion of the second source/drain of the write transistor.
40. The hybrid 2T0C gain cell according to one of clauses 31 to 39, wherein the gate of the write transistor is electrically connected to a write word line, the first source/drain of the write transistor is electrically connected to a write bit line, the first source/drain of the read transistor is electrically connected to a read word line, and the second source/drain of the read transistor is electrically connected to a read bit line.
41. The hybrid 2T0C gain cell according to one of clauses 31 to 40, wherein the hybrid 2T0C gain cell stores data at a storage node which is the gate of the read transistor and the second source/drain of the write transistor.
42. The hybrid 2T0C gain cell according to one of clauses 31 to 41, wherein the first tier is a first chiplet and the second tier is a second chiplet, and the first chiplet is hybrid bonded to the second chiplet.
43. The hybrid 2T0C gain cell according to one of clauses 31 to 42, wherein the oxide semiconductor channel includes at least one of indium oxide, indium tin oxide, indium gallium zinc oxide, tin oxide, zinc oxide, Ge-doped indium oxide, or W-doped indium oxide.
44. An embedded dynamic random access memory (eDRAM) comprising a back end of line (BEOL) structure including a plurality of layers, wherein each layer comprises a first tier, and a second tier stacked on the first tier to vertically overlap the first tier, wherein one of the first tier and the second tier comprises a write transistor having an oxide semiconductor channel and the other of the first tier and the second tier comprises a read transistor having a polysilicon channel.
45. The eDRAM according to clause 44, further comprising a front end of line (FEOL) structure comprising a logic chip, wherein the logic chip is electrically connected to the write transistor and the read transistor.
46. The eDRAM according to one of clauses 44 to 45, wherein the oxide semiconductor channel is perpendicular to the polysilicon channel in plan view.
47. The eDRAM according to one of clauses 44 to 46, wherein the second tier comprises the read transistor, and the first tier comprises the write transistor.
48. The eDRAM according to one of clauses 44 to 47, wherein the first tier comprises the read transistor, and the second tier comprises the write transistor.
49. An embedded dynamic random access memory (eDRAM) comprising a front end of line (FEOL) structure comprising one or more transistors formed in a substrate; a back end of line (BEOL) structure disposed on a top surface of the FEOL structure, the BEOL structure comprising a first tier, a second tier stacked on the first tier to vertically overlap the first tier, and a via connecting the first tier and the second tier, wherein the first tier comprises a first insulating layer and a read transistor of a two transistor zero capacitance (2T0C) gain cell disposed in the first insulating layer, the read transistor comprising a first source/drain region, a polysilicon channel region, and a second source/drain region disposed in a first direction, and a gate line disposed on top of the polysilicon channel region and extending in a second direction that is perpendicular to the first direction, wherein the second tier comprises a second insulating layer and a write transistor of the 2T0C gain cell disposed in the second insulating layer, the write transistor comprising a first source/drain region, an oxide semiconductor channel region, and a second source/drain region disposed in the second direction, and a gate line disposed on the oxide semiconductor channel region and extending the first direction, and wherein the via electrically connects the gate line of the read transistor in the first tier to the second source/drain region of the write transistor in the second tier.
50. The eDRAM according to clause 49, wherein the first source/drain region of the read transistor in the first tier is electrically connected to a read bit line, the second source/drain region of the read transistor in the first tier is electrically connected to a read word line, and wherein the first source/drain region of the write transistor in the second tier is electrically connected to a write bit line, and the gate line of the write transistor in the second tier is electrically connected to a write word line.
51. A method of manufacturing an embedded dynamic random access memory (eDRAM), the method comprising fabricating a front end of line (FEOL) structure including one or more logic chips, fabricating a first tier on the FEOL structure, and fabricating a second tier on the first tier to form the eDRAM.
52. The method according to clause 51, wherein fabricating the first tier comprises fabricating a plurality of first tiers on a top surface of the FEOL structure, each of the plurality of first tiers being spaced apart from each other in a first direction that is parallel to the top surface of the FEOL structure.
53. The method according to clause 52, wherein fabricating the second tier comprises fabricating a plurality of second tiers on the plurality first tiers, respectively.
54. A method of fabricating an embedded dynamic random access memory (eDRAM), the method comprising fabricating a first chiplet including a FEOL structure comprising one or more logic chips, fabricating a second chiplet including a first tier and a second tier on the first tier, and hybrid bonding the first chiplet and the second chiplet together to form a 3D eDRAM with heterogeneous integration.
55. The method according to clause 54, wherein fabricating the second chiplet comprises fabricating a first plurality of second chiplets, each including the first tier and the second tier on the first tier, and wherein the hybrid bonding comprises hybrid bonding each of the first plurality of second chiplets to the first chiplet.
56. The method according to clause 55, wherein fabricating the second chiplet comprises further fabricating a second plurality of second chiplets, each including the first tier and the second tier on the first tier, and wherein the hybrid bonding further comprises hybrid bonding the second plurality of chiplets to the first plurality of second chiplets, respectively.
60. A device comprising a two transistor zero capacitor (2T0C) gain cell in a back end of line structure, the 2T0C gain cell including a write transistor and a read transistor that is electrically connected to the write transistor, wherein the write transistor includes an oxide semiconductor channel and the read transistor includes a polysilicon channel.
61. The device according to clause 60, wherein the oxide semiconductor channel is stacked on the polysilicon channel.
62. The device according to claim 60 or 61, wherein the read transistor is in a first tier and the write transistor is in a second tier, and the second tier is stacked on the first tier.
63. The device according to any of clauses 60 to 62, wherein the write transistor overlaps the read transistor.
64. The device according to any of clauses 60 to 63, wherein the read transistor is connected to the write transistor by a via, and wherein the 2T0C gain cell stores data using a parasitic capacitance of the via.
65. The device according to any of clauses 60 to 64, wherein the read transistor comprises a gate, a source , and a drain, and the write transistor comprises a gate, a source, and a drain, wherein the gate of the read transistor is electrically connected to the drain of the write transistor.
66. The device according any of clause 60 to 65, wherein a gate line of the read transistor is connected to a drain region of the write transistor through a via.
67. The device according to any of clauses 60 to 66, wherein a portion of a gate line of the read transistor overlaps a portion of a drain region of the write transistor, and a via connects the portion of the gate line of the read transistor to the portion of the drain region of the write transistor.
68. The device according to any of clauses 60 to 67, wherein the read transistor comprises a gate, a source, and a drain, and the write transistor comprises a gate, a source, and a drain, wherein the gate of the read transistor is electrically connected to the drain of the write transistor, and wherein the gate of the write transistor is electrically connected to a write word line, the source of the write transistor is electrically connected to a write bit line, the source of the read transistor is electrically connected to a read word line, and the drain of the read transistor is electrically connected to a read bit line.
69. The device according to any of clauses 60 to 68, wherein the a gate of the read transistor is electrically connected to a drain of the write transistor, and wherein the 2T0C gain cell stores data using a parasitic capacitance at the gate of the read transistor.
70. The device according to any of clauses 60 to 69, wherein the read transistor is included in a first chiplet and the write transistor is included in a second chiplet, and the first chiplet is hybrid bonded to the second chiplet.
71. The device according to any of clauses 60 to 70, wherein the oxide semiconductor channel includes at least one of indium oxide, indium tin oxide, indium gallium zinc oxide, tin oxide, zinc oxide, Ge-doped indium oxide, or W-doped indium oxide.
72. A system comprising a front end of line (FEOL) structure comprising a logic chip; and a back end of line (BEOL) structure on the FEOL structure, the BEOL structure including a layer, wherein the layer comprises a two transistor zero capacitor (2T0C) gain cell including a read transistor, and write transistor that is electrically connected to the read transistor, and wherein the write transistor includes an oxide semiconductor channel and the read transistor includes a polysilicon channel.
73. The system according to clause 72, wherein the logic chip is electrically connected to the write transistor and the read transistor.
74.The system according to clause 72 or 73, wherein the oxide semiconductor channel is stacked on to the polysilicon channel.
75. The system according to any of clauses 72 to 74, wherein the read transistor is in a first tier and the write transistor is in a second tier, and the second tier is stacked on the first tier.
76. The system according to any of clauses 72 to 75, wherein the read transistor is connected to the write transistor by a via, and wherein the 2T0C gain cell stores data using a parasitic capacitance of the via.
77. A method comprising fabricating a first structure using a front end of line (process), the first structure including a logic chip; fabricating a first tier using a back end of line (BEOL) process, the first tier comprising a read transistor of a two transistor zero capacitor gain cell; and fabricating a second tier on the first tier using the BEOL process, the second tier including a write transistor of the 2T0C gain cell.
78. The method according to clause 77, wherein the first tier is fabricated on the first structure.
79. The method according to clause 77, wherein the first tier is bonded to the first structure by hybrid bonding.

It should be understood that embodiments are not limited to the various embodiments described above, but various other changes and modifications may be made therein without departing from the spirit and scope thereof as set forth in appended claims.

## Claims

1. A device comprising:
a two transistor zero capacitor gain cell (1) in a back end of line structure, the two transistor zero capacitor gain cell (1) including a write transistor (Tw) and a read transistor (Tr) that is electrically connected to the write transistor (Tw),
wherein the write transistor (Tw) includes an oxide semiconductor channel (380) and the read transistor (Tr) includes a polysilicon channel (280).

2. The device according to claim 1, wherein the oxide semiconductor channel (380) is stacked on the polysilicon channel (280).

3. The device according to claim 1 or 2, wherein the read transistor (Tr) is in a first tier (Tier 1) and the write transistor (Tw) is in a second tier (Tier 2), and the second tier (Tier 2) is stacked on the first tier (Tier 1).

4. The device according to any one of claims 1 to 3, wherein the write transistor (Tw) overlaps the read transistor (Tr).

5. The device according to any one of claims 1 to 4, wherein the read transistor (Tr) is connected to the write transistor (Tw) by a via (250), and
wherein the two transistor zero capacitor gain cell (1) stores data using a parasitic capacitance of the via (250).

6. The device according to any one of claims 1 to 5, wherein the read transistor (Tr) comprises a gate, a source, and a drain, and the write transistor (Tw) comprises a gate, a source, and a drain,
wherein the gate of the read transistor (Tr) is electrically connected to the drain of the write transistor (Tw).

7. The device according to any one of claims 1 to 4, wherein a gate line (220) of the read transistor (Tr) is connected to a drain region (340) of the write transistor (Tw) through a via (250).

8. The device according to any one of claims 1 to 4, wherein a portion of a gate line (220) of the read transistor (Tr) overlaps a portion of a drain region (340) of the write transistor (Tw), and a via (250) connects the portion of the gate line (220) of the read transistor (Tr) to the portion of the drain region (340) of the write transistor (Tw).

9. The device according to any one of claims 1 to 5, wherein the read transistor (Tr) comprises a gate, a source, and a drain, and the write transistor (Tw) comprises a gate, a source, and a drain,
wherein the gate of the read transistor (Tr) is electrically connected to the drain of the write transistor (Tw), and
wherein the gate of the write transistor (Tw) is electrically connected to a write word line (WWL), the source of the write transistor (Tw) is electrically connected to a write bit line (WBL), the source of the read transistor (Tr) is electrically connected to a read word line (RWL), and the drain of the read transistor (Tr) is electrically connected to a read bit line (RBL).

10. The device according to any one of claims 1 to 4, wherein a gate of the read transistor (Tr) is electrically connected to a drain of the write transistor (Tw), and
wherein the two transistor zero capacitor gain cell (1) stores data using a parasitic capacitance at the gate of the read transistor (Tr).

11. The device according to any one of claims 1 to 10, wherein the read transistor (Tr) is included in a first chiplet and the write transistor (Tw) is included in a second chiplet, and the first chiplet is hybrid bonded to the second chiplet.

12. The device according to any one of claims 1 to 11, wherein the oxide semiconductor channel (380) includes at least one of indium oxide, indium tin oxide, indium gallium zinc oxide, tin oxide, zinc oxide, Ge-doped indium oxide, or W-doped indium oxide.

13. A system comprising:
a front end of line structure (500) comprising a logic chip; and
a back end of line structure (600) on the front end of line structure (500), the back end of line structure (500) including a layer,
wherein the layer comprises the device according to any one of claims 1 to 12.

14. The system according to claim 13, wherein the logic chip is electrically connected to the write transistor (Tw) and the read transistor (Tr).
